# EUROPÄISCHE PATENTSCHRIFT

(11) **EP 2 478 601 B1**
(45) Veröffentlichungstag und Bekanntmachung des Hinweises auf die Patenterteilung: **06.12.2017**
(21) Anmeldenummer: 10748092.3
(22) Anmeldetag: 01.09.2010
(51) Int. Cl.: H01S 5/20, H01S 5/343

(54) **KANTENEMITTIERENDER HALBLEITERLASER**
EDGE-EMITTING SEMICONDUCTOR LASER
LASER À SEMI-CONDUCTEURS À ÉMISSION PAR LA TRANCHE

(30) Priorität: 17.09.2009 DE 102009041934
(43) Veröffentlichungstag der Anmeldung: 25.07.2012
(73) Patentinhaber: OSRAM Opto Semiconductors GmbH, 93055 Regensburg (DE)
(72) Erfinder: GOMEZ-IGLESIAS, Alvaro, 93047 Regensburg (DE); GRÖNNINGER, Günther, 92358 Seubersdorf (DE); LAUER, Christian, 93053 Regensburg (DE); KÖNIG, Harald, 93170 Bernhardswald (DE)
(74) Vertreter: Epping - Hermann - Fischer
(86) Internationale Anmeldenummer: PCT/EP2010/062812
(87) Internationale Veröffentlichungsnummer: WO 2011/032841

(56) Entgegenhaltungen:
- EP-A1- 1 727 250
- WO-A1-00/05792
- WO-A1-91/16747
- WO-A1-2004/084366
- US-A1- 2005 201 439
- US-A1- 2007 183 469
- US-A1- 2009 080 484
- D FEDEKE ET AL: "InGaAs/GaAs 0.98-[mu]m low-divergence central-lobe semiconductor lasers with [delta]-doped resonant tunneling quantum wells", IEEE JOURNAL OF QUANTUM ELECTRONICS IEEE USA, Bd. 45, Nr. 6, 1. Juni 2009 (2009-06-01), Seiten 700-710, XP002664287, ISSN: 0018-9197, DOI: DOI:10.1109/JQE.2009.2013145

## Beschreibung

Die vorliegende Anmeldung betrifft einen kantenemittierenden Halbleiterlaser.
Kantenemittierende Halbleiterlaser weisen in der Regel einen Wellenleiter auf, um die Strahlung, die in einer aktiven Zone des Halbleiterlasers erzeugt wird, innerhalb des Halbleiterlasers zu führen. 1 Die Patentanmeldung WO0116747 offenbart einen kantenemittierenden Halbleiterlaser mit einer aktiven Zone und n-dotierten und p-dotierten Wellenleiter. Konventionelle Wellenleiter umfassen in der Regel p-dotierte Halbleiterschichten, die aufgrund der geringen Lochmobilitäten zu einem hohen Serienwiderstand des Bauteils führen können. Um den Serienwiderstand eines solchen Bauelementes zu vermindern, wurde beispielsweise versucht, die p-Dotierung des p-dotierten Bereiches des Wellenleiters heraufzusetzen. Hierbei besteht jedoch die Gefahr, dass die Verluste des Wellenleiters ansteigen, was in der Erhöhung des Schwellstroms des Lasers resultieren kann.
Eine Aufgabe der vorliegenden Erfindung ist es, einen kantenemittierenden Halbleiterlaser mit einem verbesserten Wellenleiter anzugeben, der einen niedrigen Serienwiderstand des Halbleiterlasers ermöglicht und sehr hohe Effizienz bei hohen Strömen ermöglicht.
Diese Aufgabe wird durch einen kantenemittierenden Halbleiterlaser mit den Merkmalen des Patentanspruchs 1 gelöst.

Vorteilhafte Ausführungsformen und Weiterbildungen sind in den abhängigen Ansprüchen angegeben.

Ein kantenemittierender Halbleiterlaser umfasst insbesondere:
- eine aktive strahlungserzeugende Zone, und
- einen Gesamtwellenleiter, der dazu geeignet ist, die in der aktiven Zone erzeugte Strahlung innerhalb des Halbleiterlasers zu führen, wobei
- der Gesamtwellenleiter eine erste n-dotierte Schicht und eine zweite n-dotierte Schicht umfasst, wobei die zweite n-dotierte Schicht zwischen der ersten n-dotierten Schicht und der aktiven Zone angeordnet ist, und
- der Brechungsindex n₂ der zweiten n-dotierten Schicht um einen Betrag dn größer ist als der Brechungsindex n₁ der ersten n-dotierten Schicht.

Als Confinement-Faktor (CF) wird im Folgenden der Überlapp der jeweiligen Lasermode des Halbleiterlasers mit der strahlungserzeugenden aktiven Zone des Halbleiterlasers bezeichnet. Weiterhin wird die Lasermode erster Ordnung auch mit dem Begriff "fundamentale Lasermode" bezeichnet.

Dem Gesamtwellenleiter kommt die Aufgabe zu, den Confinement-Faktor der fundamentalen Lasermode gegenüber den Confinement-Faktoren der Lasermoden höherer Ordnung zu erhöhen. Der Gesamtwellenleiter umfasst vorliegend einen primären Wellenleiter sowie zumindest einen weiteren Wellenleiter höherer Ordnung, in der Regel einen sekundären Wellenleiter.

Der primäre Wellenleiter führt die fundamentale Mode. Der Begriff "Führung" bedeutet dabei, dass mindestens 50% der Gesamtintensität der Mode innerhalb des jeweiligen Wellenleiters konzentriert ist.

Der primäre Wellenleiter umfasst bevorzugt die aktive Zone und die zweite n-dotierte Schicht. Der primäre Wellenleiter kann weiterhin einen so genannten Nebentopf umfassen. Ein Nebentopf wird beispielsweise durch einen undotierten Bereich gebildet, der die aktive Zone einbettet. Der undotierte Bereich weist in der Regel einen höheren Brechungsindex auf als die Schichten des Gesamtwellenleiters.

Der sekundäre Wellenleiter beinhaltet den primären Wellenleiter und angrenzend an die zweite n-dotierte Schicht die erste n-dotierte Schicht, wobei der Brechungsindex n₂ der zweiten n-dotierten Schicht um einen Betrag dn größer ist als der Brechungsindex n₁ der ersten n-dotierten Schicht. Der sekundäre Wellenleiter ist dazu vorgesehen, zumindest die Mode zweiter Ordnung, falls kein Wellenleiter höherer Ordnung vorgesehen ist, alle Moden höherer Ordnung zu führen.

Auch noch höhere Wellenleiter zur Führung von Moden höherer Ordnung sind denkbar. Die Materialzusammensetzung und Dicke der jeweiligen Schichten, die den jeweiligen Wellenleiter bilden, muss derart gewählt sein, dass der effektive Brechungsindex der fundamentalen Mode groß genug ist, damit die fundamentalen Mode im primären, aber nicht im sekundären und - falls vorhanden - in höheren Wellenleitern geführt ist.

Es sei an dieser Stelle darauf hingewiesen, dass der Gesamtwellenleiter neben den oben aufgeführten Schichten weitere Schichten umfassen kann. Diese weiteren Schichten können Teil des primären Wellenleiters, des sekundären Wellenleiters oder auch eines Wellenleiters höherer Ordnung sein.

Ein Ziel der vorliegenden Erfindung ist es, durch Einführung von primären und höheren Wellenleitern, die die verschiedenen Lasermoden unterschiedlich führen, die Confinement-Faktoren der verschiedenen Moden günstig zu beeinflussen. Insbesondere wird angestrebt, den Confinement-Faktor der fundamentalen Lasermode gegenüber dem Confinement-Faktor von Lasermoden höherer Ordnung zu erhöhen.

Gemäß die Erfindung ist der Gesamtwellenleiter frei von einer p-dotierten Schicht, oder weist der Gesamtwellenleiter nur eine einzige p-dotierte Schicht auf, deren Dicke nicht größer ist als 10% der Dicke des Gesamtwellenleiters Falls vorliegend von n-dotierten oder p-dotierten Schichten die Rede ist, ist hiermit gemeint, dass diese Schichten entsprechende zusätzliche Dotierstoffe (n- oder p-Dotierstoffe) aufweisen. Unter undotierten Schichten werden vorliegend Schichten verstanden, in die keine zusätzlichen Dotierstoffe gezielt eingebracht sind. Solche undotierten Schichten können jedoch sehr wohl eine intrinsische Dotierung aufweisen, die unvermeidlich bei der Abscheidung der Schichten, beispielsweise durch epitaktisches Wachstum in einem Reaktor, entsteht.
In diesem Sinne bedeutet, dass der Gesamtwellenleiter "frei von einer p-dotierten Schicht" ist, dass der Gesamtwellenleiter keine Schicht aufweist, die zusätzlich gezielt mit einem p-Dotierstoff dotiert wurde.

Gemäß eine Ausführung der Erfindung weist der Gesamtwellenleiter des Halbleiterlasers nur eine einzige sehr dünne p-dotierte Schicht auf, die kleiner oder gleich 10% der Dicke des Gesamtwellenleiters ist, beispielsweise kleiner oder gleich 200 nm. Es sei an dieser Stelle darauf hingewiesen, dass die p-dotierte Schicht nicht notwendigerweise homogen hinsichtlich des Materials ausgebildet sein muss. Vielmehr kann die Materialzusammensetzung innerhalb der p-dotierte Schicht variieren.
Weist der Gesamtwellenleiter keine oder nur sehr dünne p-dotierte Schichten auf, so hat dies den Vorteil, dass der Serienwiderstand des Halbleiterlasers gegenüber einem herkömmlichen Halbleiterlaser mit dickeren p-dotierten Wellenleiterschichten bei gleicher Gesamtdicke des Gesamtwellenleiters erniedrigt ist. Gemäß die Erfindung ist die fundamentale Mode der Laserstrahlung im Wesentlichen auf die zweite n-dotierte Schicht begrenzt. Dies bedeutet vorliegend, dass mehr als die Hälfte der Intensität in der zweiten n-dotierten Schicht sowie der aktiven Zone konzentriert ist.
Gemäß einer weiteren bevorzugten Ausführungsform des Halbleiterlasers weist der Gesamtwellenleiter weiterhin eine erste undotierte Schicht auf, die zwischen der aktiven Zone und der zweiten n-dotierten Schicht angeordnet ist, wobei der Brechungsindex n₃ der ersten undotierten Schicht größer ist als der Brechungsindex n₂ der zweiten n-dotierten Schicht. Bei dieser Ausführungsform ist weiterhin bevorzugt innerhalb des Gesamtwellenleiters eine zweite undotierte Schicht angeordnet, die auf der Seite der aktiven Zone angeordnet ist, die der ersten undotierten Schicht gegenüberliegt. In diesem Fall ist die aktive Zone innerhalb der beiden undotierten Schichten eingebettet. Die beiden undotierten Schichten bilden einen undotierten Bereich aus, der einen Nebentopf bilden kann.

Weiterhin ist es bei dieser Ausführungsform, bei der der Gesamtwellenleiter neben der ersten n-dotierten Schicht und der zweiten n-dotierten Schicht zwei undotierte Schichten aufweist, in die die aktive Zone eingebettet ist, möglich, dass die erste undotierte Schicht und die zweite undotierte Schicht unterschiedliche Dicken aufweisen. In diesem Fall ist die aktive Zone somit asymmetrisch innerhalb eines undotierten Bereiches angeordnet, der durch die erste und die zweite undotierte Schicht gebildet ist. Besonders bevorzugt ist hierbei die erste undotierte Schicht, die zwischen der aktiven Zone und der zweiten n-dotierten Schicht angeordnet ist, dünner ausgebildet als die zweite undotierte Schicht, die auf der Seite der aktiven Zone angeordnet ist, die von der ersten undotierten Schicht abgewandt ist. Dadurch kann der Confinement-Faktor der fundamentalen Mode vorteilhafterweise weiter erhöht werden.

Gemäß einer weiteren Ausführungsform des Halbleiterlasers weist der Gesamtwellenleiter zudem eine n-dotierte Mantelschicht und eine p-dotierte Mantelschicht auf. Eine Schicht wird vorliegend als "Mantelschicht" bezeichnet, wenn ihr Brechungsindex kleiner ist, als der effektive Brechungsindex der gerade betrachteten Mode.

In der Regel sind die Halbleiterschichten des Halbleiterlasers, wie die aktive Zone, die erste undotierte Schicht, die zweite undotierte Schicht, die erste n-dotierte Schicht, die zweite n-dotierte Schicht, aber auch die Mantelschichten epitaktisch auf einem Aufwachssubstrat gewachsen. Das Aufwachssubstrat kann eines der folgenden Materialien aufweisen oder aus einem der folgenden Materialien bestehen: Galliumarsenid, Indiumphosphid, Indiumarsenid, Indiumantimonid, Galliumantimonid, Galliumnitrid. Falls das Wachstumssubstrat einen höheren Brechungsindex aufweist, als die Schicht des Gesamtwellenleiters, die dem Wachstumssubstrat am nächsten ist, so ist zwischen dem Gesamtwellenleiter und dem Wachstumssubstrat bevorzugt eine n-dotierte Mantelschicht oder eine p-dotierte Mantelschicht angeordnet. Die Dotierung der Mantelschicht orientiert sich hierbei in der Regel an der Dotierung der benachbarten Schichten des Gesamtwellenleiters, das heißt, dass zwischen dem Wachstumssubstrat und dem Gesamtwellenleiter bevorzugt eine n-dotierte Mantelschicht angeordnet wird, falls die dem Wachstumssubstrat benachbart angeordnete Schicht des Gesamtwellenleiters n-dotiert ist. Ist die dem Wachstumssubstrat benachbart angeordnete Schicht des Gesamtwellenleiters jedoch p-dotiert, so wird in der Regel eine p-dotierte Mantelschicht zwischen Aufwachssubstrat und Gesamtwellenleiter positioniert.

Mittels der p-dotierten Mantelschicht oder der n-dotierten Mantelschicht zwischen Aufwachssubstrat und Gesamtwellenleiter werden die Moden der Laserstrahlung vorteilhafterweise wirksam von dem Aufwachssubstrat entkoppelt. Hierdurch wird die Effizienz des Halbleiterlasers erhöht, da die Moden der Laserstrahlung ansonsten hohe optische Absorptionsverluste erfahren würden und/oder das vertikale Fernfeld des Halbleiterlasers gestört werden kann.

Hierbei ist in der Regel die n-dotierte Mantelschicht benachbart zur ersten n-dotierten Schicht des Gesamtwellenleiters angeordnet, während die p-dotierte Mantelschicht auf der Seite der aktiven Zone angeordnet ist, die den n-dotierten Schichten gegenüber liegt.

Gemäß einer weiteren bevorzugten Ausführungsform liegt der Confinement-Faktor der fundamentalen Mode des Halbleiterlasers pro Quantentopf zwischen 1% und 0,4% und besonders bevorzugt zwischen 0,6% und 0,4%, wobei jeweils die Grenzen eingeschlossen sind.

Gemäß einer weiteren Ausführungsform liegt der Brechungsindexunterschied dn zwischen der ersten n-dotierten Schicht und der zweiten n-dotierten Schicht zwischen 0,03 und 0,1, wobei die Grenzen eingeschlossen sind. Ist der Brechungsindexunterschied dn relativ gering, so breitet sich die fundamentale Mode auch innerhalb der ersten n-dotierten Schicht aus, wodurch die Breite des Fernfeldes des Halbleiterlaser vorteilhafterweise deutlich verringert wird.

Die Dicke der zweiten n-dotierten Schicht liegt weiterhin bevorzugt zwischen 200 nm und 800 nm, wobei wiederum die Grenzen eingeschlossen sind.

Besonders bevorzugt beträgt die Dicke der zweiten n-dotierten Schicht zwischen 8% und 20% bezogen auf die Dicke des Gesamtwellenleiters.

Gemäß einer weiteren Ausführungsform zeigt die Konzentration des n-Dotierstoffes innerhalb der ersten n-dotierten Schicht einen Verlauf, der zu der Außenseite des Gesamtwellenleiters hin stufenartig oder kontinuierlich ansteigt. Auf diese Art und Weise können in der Regel optische Verluste aufgrund der Absorption an freien Ladungsträgern für Lasermoden höherer Ordnung erhöht werden, um die Ausbildung von Moden höherer Ordnung neben der fundamentalen Lasermode innerhalb des Halbleiterlasers zu unterdrücken.

Gemäß einer weiteren Ausführungsform basiert der kantenemittierende Halbleiterlaser auf einem Arsenid-Verbindungshalbleitermaterial.

"Auf Arsenid-Verbindungshalbleitermaterial basierend" bedeutet in diesem Zusammenhang, dass insbesondere die strahlungserzeugende aktive Zone des kantenemittierenden Halbleiterlasers vorzugsweise AlₙGaₘIn₁₋ₙ₋ₘAs umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die jedoch insbesondere den Brechungsindex des Materials nicht wesentlich ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

Ein Halbleiterlaser, der auf einem Arsenid-Verbindungshalbleitermaterial basiert, ist insbesondere dazu geeignet, Laserstrahlung aus dem infraroten Spektralbereich auszusenden.

Die Erfindung wird im Folgenden anhand von Ausführungsbeispielen in Verbindung mit den Figuren näher erläutert.

Es zeigen:
- Figur 1,: eine schematische Schnittdarstellung eines kantenemittierenden Halbleiterlasers gemäß einem ersten Ausführungsbeispiel,
- Figur 2,: eine schematische Darstellung des Brechungsindexes n des kantenemittierenden Halbleiterlasers gemäß dem Ausführungsbeispiel der Figur 1 entlang der Richtung R in Abhängigkeit des Abstandes b,
- Figur 3,: eine schematische Darstellung des Brechungsindexverlaufes des Halbleiterlasers gemäß dem Ausführungsbeispiel der Figur 1 mit den Intensitätsprofilen I der optischen Moden bis zur vierten Ordnung innerhalb des Gesamtwellenleiters,
- Figur 4,: eine schematische Darstellung des Confinement-Faktors CF für verschiedene Moden des Halbleiterlasers gemäß dem Ausführungsbeispiel der Figur 1 als Funktion der Dicke d der zweiten n-dotierten Schicht,
- Figur 5,: eine schematische Darstellung des Brechungsindexverlaufes des Halbleiterlasers gemäß dem Ausführungsbeispiel der Figur 1 sowie drei verschiedene Profile der n-Dotierstoffkonzentration cₙ entlang der Richtung R gemäß dreier verschiedener Ausführungsbeispiele.
- Figur 6,: eine schematische Darstellung des Brechungsindexverlaufes n eines kantenemittierenden Halbleiterlasers gemäß einem zweiten Ausführungsbeispiel mit den Intensitätsprofilen der optischen Moden bis zur vierten Ordnung innerhalb des Gesamtwellenleiters,
- Figur 7,: eine schematische Darstellung des Confinement-Faktors CF für verschiedene Moden des Halbleiterlasers gemäß dem zweiten Ausführungsbeispiel als Funktion der Dicke d der zweiten n-dotierten Schicht,
- Figur 8,: eine schematische Darstellung des Brechungsindexverlaufes n eines kantenemittierenden Halbleiterlasers gemäß einem dritten Ausführungsbeispiel mit den Intensitätsprofilen der optischen Moden bis zur vierten Ordnung innerhalb des Gesamtwellenleiters, und
- Figur 9,: eine schematische Darstellung des Confinement-Faktors CF für verschiedene Moden des Halbleiterlasers gemäß dem dritten Ausführungsbeispiel als Funktion der Dicke d der zweiten n-dotierten Schicht.

Gleiche oder gleich wirkende Elemente sind in den Figuren mit den gleichen Bezugszeichen versehen. Die Figuren sind nicht als maßstabsgerecht anzusehen, vielmehr können einzelne Elemente, beispielsweise Schichtdicken, zur Verdeutlichung übertrieben groß dargestellt sein.

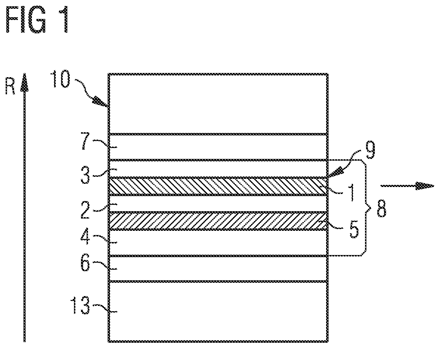

Der kantenemittierende Halbleiterlaser gemäß dem Ausführungsbeispiel der Figur 1 weist eine aktive Zone 1 auf, die dazu geeignet ist, elektromagnetische Strahlung zu erzeugen.

Zur Strahlungserzeugung weist die aktive Zone 1 bevorzugt einen pn-Übergang, eine Doppelheterostruktur, einen Einfach-Quantentopf oder eine Mehrfach-Quantentopfstruktur (MQW) auf. Besonders bevorzugt weist die aktive Zone 1 einen Einfach-Quantentopf zur Strahlungserzeugung auf. Die Bezeichnung Quantentopfstruktur beinhaltet hierbei keine Angabe über die Dimensionalität der Quantisierung. Sie umfasst somit u.a. Quantentröge, Quantendrähte und Quantenpunkte und jede Kombination dieser Strukturen.

Die aktive Zone 1 ist bei dem Halbleiterlaser gemäß dem Ausführungsbeispiel der Figur 1 zwischen einer ersten undotierten Schicht 2 und einer zweiten undotierten Schicht 3 angeordnet. Die erste undotierte Schicht 2 und die zweite undotierte Schicht 3 sind hierbei direkt angrenzend an die aktive Zone 1 angeordnet, d.h. die erste undotierte Schicht 2 und die zweite undotierte Schicht 3 bilden jeweils eine gemeinsame Grenzfläche mit der aktiven Zone 1 aus. Die aktive Zone 1 ist somit in einen undotierten Bereich eingebettet, der durch die erste undotierte Schicht 2 und die zweite undotierte Schicht 3 gebildet werden. Die erste undotierte Schicht 2 und die zweite undotierte Schicht 3 bilden einen undotierten Bereich aus, der als Nebentopf wirkt.

Weiterhin umfasst der Halbleiterlaser gemäß Figur 1 eine erste n-dotierte Schicht 4 und eine zweite n-dotierte Schicht 5, wobei die zweite n-dotierte Schicht 5 zwischen der aktiven Zone 1 und der ersten n-dotierte Schicht 4 angeordnet ist. Vorliegend ist die zweite n-dotierte Schicht 5 in direktem Kontakt mit der ersten undotierten Schicht 2 und die erste n-dotierte Schicht 4 in direktem Kontakt mit der zweiten n-dotierten Schicht 5 angeordnet, d.h die zweite n-dotierte Schicht 5 bildet mit der ersten undotierten Schicht 2 eine gemeinsame Grenzfläche aus und die erste n-dotierte Schicht 4 bildet mit der zweiten n-dotierten Schicht 5 eine gemeinsame Grenzfläche aus.

Die aktive Zone 1, die beiden undotierten Schichten 2, 3 und die beiden n-dotierten Schichten 4, 5 bilden vorliegend den Gesamtwellenleiter 8 des Halbleiterlaser, der dazu geeignet ist, die in der aktiven Zone 1 erzeugte Strahlung innerhalb des Halbleiterlasers zu führen. Die aktive Zone 1 ist vorliegend innerhalb des Gesamtwellenleiters 8 angeordnet, und zwar symmetrisch zwischen den beiden undotierten Schichten 2, 3, die den undotierten Bereich des Gesamtwellenleiters 8 bilden. Die beiden undotierten Schichten 2, 3 weisen mit anderen Worten die gleiche Dicke auf.

Benachbart zur ersten n-dotierten Schicht 4 ist weiterhin eine n-dotierte Mantelschicht 6 angeordnet, während auf der der n-dotierten Mantelschicht 6 gegenüberliegenden Seite der aktive Zone 1 benachbart zur zweiten undotierten Schicht 3 eine p-dotierte Mantelschicht 7 positioniert ist. Die p-dotierte Mantelschicht 7 ist vorliegend in direktem Kontakt mit der zweiten undotierten Schicht 3 angeordnet, dass heißt die p-dotierte Mantelschicht 7 bildet mit der zweiten undotierten Schicht 3 eine gemeinsame Grenzfläche aus.

Die Schichten des Gesamtwellenleiters 8, das heißt vorliegend die aktive Zone 1, die erste undotierte Schicht 2, die zweite undotierte Schicht 3, die erste n-dotierte Schicht 4, die zweite n-dotierte Schicht 5 sind epitaktisch auf einem Aufwachssubstrat 13 gewachsen. Die Schichten des Gesamtwellenleiters 8 sind durch eine n-dotierte Mantelschicht 6 von dem Aufwachssubstrat 13 getrennt.

Der Gesamtwellenleiter 8 des Halbleiterlasers gemäß der Figur 1 ist frei von einer p-dotierten Schicht. Sein Serienwiderstand ist daher vorteilhafterweise gegenüber einem Bauelement mit p-dotierten Schichten innerhalb des Gesamtwellenleiters 8 herabgesetzt. Der Serienwiderstand des Halbleiterlasers bezogen auf die Fläche ist bevorzugt kleiner oder gleich 2*10⁻⁴ Ωcm², besonders bevorzugt kleiner oder gleich 10⁻⁵ Ωcm².

Der Halbleiterlaser weist an seinen beiden Seitenflächen 9, 10, die senkrecht zu der Haupterstreckungsebene der aktiven Zone 1 stehen, Facetten auf, die dazu geeignet sind, die in der aktiven Zone 1 erzeugte Strahlung zu reflektieren. Daher bildet sich im Betrieb des Halbleiterlasers entlang der Haupterstreckungsebene der aktiven Zone 1 eine stehende Welle aus elektromagnetischer Strahlung innerhalb des Halbleiterlasers aus, die die Laserstrahlung darstellt. Diese Laserstrahlung wird in der Regel durch eine der Facetten ausgekoppelt.

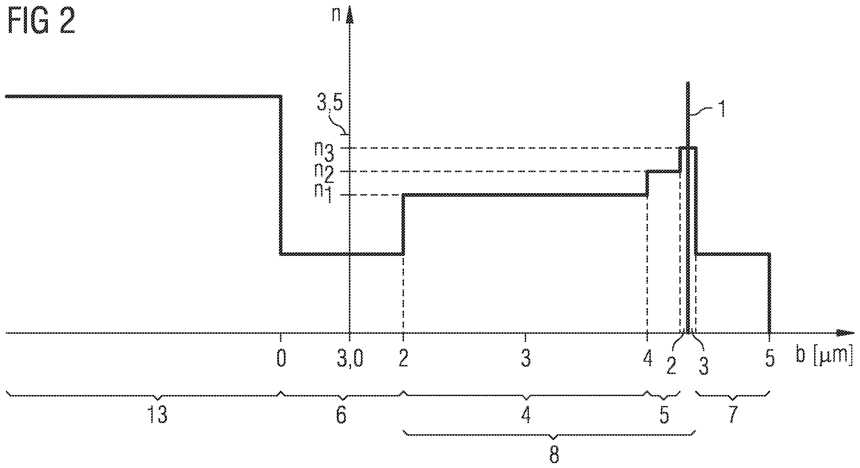

In Figur 2 ist der Verlauf des Brechungsindexes n innerhalb des Halbleiterlasers entlang der Richtung R gemäß Figur 1 in Abhängigkeit der Dicke b der Schichten des Halbleiterlasers dargestellt. Das Brechungsindexprofil beginnt hierbei mit dem Brechungsindex des Aufwachssubstrats 13, der bei ca. 3,6 liegt. Angrenzend an das Aufwachssubstrat 13 ist die n-dotierte Mantelschicht 6 angeordnet, die eine Dicke zwischen ca. 0,7 und ca. 1 µm und einen Brechungsindex von ca. 3,2 aufweist. Die n-dotierte Mantelschicht 6 hat vorliegend die Aufgabe, die Moden der Laserstrahlung von dem Aufwachssubstrat 13 zu entkoppeln.

Die erste n-dotierte Schicht 4, die sich in direktem Kontakt mit der n-dotierten Mantelschicht 6 befindet, weist eine Dicke von ca. 1,8 µm und einen Brechungsindex n₁ von ca. 3,37 auf. Direkt angrenzend an die erste n-dotierte Schicht 4 ist weiterhin die zweite n-dotierte Schicht 5 angeordnet, die eine Dicke von ca. 0,35 µm und einen Brechungsindex n₂ von ca. 3,41 aufweist.

Der Brechungsindex n₂ der zweiten n-dotierten Schicht 5 ist somit um einen Betrag dn von ca. 0,04 größer als der Brechungsindex n₁ der ersten n-dotierten Schicht 4.

Besonders bevorzugt liegt der Brechungsindexunterschied dn zwischen der ersten n-dotierten Schicht 4 und der zweiten n-dotierten Schicht 5 zwischen 0,04 und 0,05, wobei die Grenzen eingeschlossen sein.

Die erste undotierte Schicht 2 und die zweite undotierte Schicht 3 weisen beide eine Dicke zwischen 10 nm und 100 nm und einen Brechungsindex von ca. 3,45 auf. Der Brechungsindex n₃ der ersten undotierten Schicht 2 ist somit größer als der Brechungsindex n₂ der zweiten n-dotierten Schicht 5. Die aktive Zone 1, die in die beiden undotierten Schichten 2, 3 eingebettet ist, weist einen Brechungsindex von ca. 3,6 auf. Die Dicke der aktiven Zone 1 liegt in der Regel zwischen 3 nm und 12 nm, beispielsweise bei ca. 7 nm.

Die p-dotierte Mantelschicht 7, die direkt angrenzend an die zweite undotierte Schicht 3 angeordnet ist, weist vorliegend eine Dicke von ca. 0,7 µm und einen Brechungsindex von ca. 3,2 auf.

Der Halbleiterlaser basiert vorliegend auf einem Arsenid-Verbindungshalbleitermaterial und ist dazu geeignet, Laserstrahlung aus dem infraroten Spektralbereich mit einer Wellenlänge von ca. 965 nm zu emittieren.

Das vorliegende Konzept für einen Gesamtwellenleiter eines kantenemittierenden Halbleiterlasers ist jedoch nicht auf diese Materialgruppe oder auf diese Emissionswellenlänge eingeschränkt. Vielmehr kann das vorliegende Konzept auch auf andere Materialien sowie Emissionswellenlängen, beispielsweise 808 nm, angewendet werden.

Die n-dotierte Mantelschicht 6 und die p-dotierte Mantelschicht 7, die erste n-dotierte Schicht 4 und die zweite n-dotierte Schicht 5 sowie die erste undotierte Schicht 2 und die zweite undotierte Schicht 3 weisen AlGaAs mit unterschiedlichem Aluminiumgehalt auf. Der unterschiedliche Aluminiumgehalt der Schichten führt hierbei zu den oben beschriebenen Unterschieden in den Brechungsindizes der Schichten.

Die p-dotierte Mantelschicht 7 und die n-dotierte Mantelschicht 6 weisen einen Aluminiumgehalt von ca. 50% auf, während der Aluminiumgehalt der beiden undotierten Schichten 2, 3 ca. 11% beträgt. Die erste n-dotierte Schicht 4 weist einen Aluminiumgehalt von ca. 25% auf, während die zweite n-dotierte Schicht 5 einen Aluminiumgehalt von ca. 19% hat.

Die aktive Zone 1 weist vorliegend zur Strahlungserzeugung InGaAs-Quantenstrukturen auf. Die aktive Zone 1 enthält im Unterschied zu den restlichen Schichten vorliegend kein Aluminium. Es sei jedoch darauf hingewiesen, dass die aktive Zone 1 insbesondere für Emissionswellenlängen kleiner 850 nm in der Regel Aluminium aufweist.

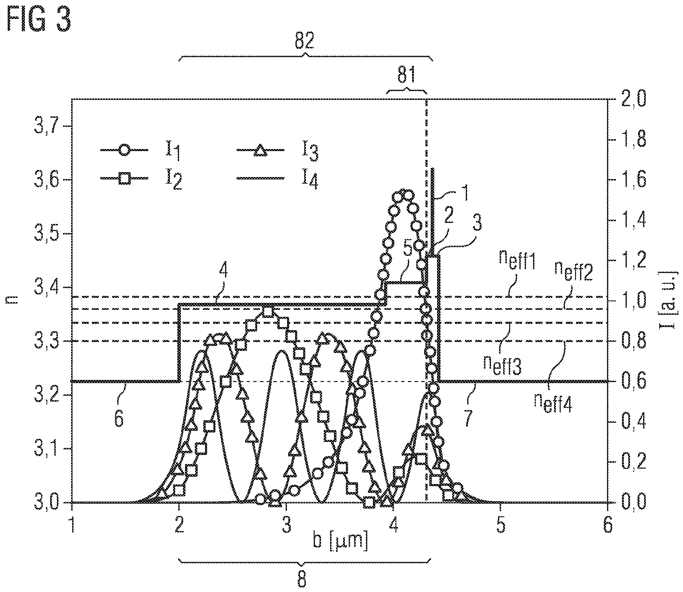

Figur 3 zeigt den Brechungsindexverlauf des Halbleiterlasers gemäß Figur 1, wie er anhand der Figur 2 bereits beschrieben wurde. Weiterhin sind in Figur 3 die Intensitäten I₁, I₂, I₃, I₄ der Moden der Laserstrahlung, die sich innerhalb des Gesamtwellenleiters 8 ausbilden, bis zur vierten Ordnung sowie deren effektive Brechungsindizes n_{eff1}, n_{eff2}, n_{eff3}, n_{eff4}, aufgetragen.

Die fundamentale Mode der Laserstrahlung, dass heißt, die Mode der ersten Ordnung, ist hierbei deutlich innerhalb der zweiten n-dotierten Schicht 5 lokalisiert, dass heißt, dass mindestens die Hälfte der Intensität der fundamentalen Mode innerhalb der zweiten n-dotierten Schicht 5 lokalisiert ist. Der Intensitätsverlauf I₁ der fundamentale Mode weist hierbei ein einziges Maximum mit einem normierten Wert von ca. 1,6 auf, das sich innerhalb der zweiten n-dotierten Schicht 5 befindet. Die Intensität I₁ fällt hierbei von seinem Maximum steil zu den undotierten Schichten 2, 3 und der aktiven Zone 1 ab und zeigt einen kleinen abfallenden Ausläufer in die p-dotierte Mantelschicht 7. Auf der von der aktiven Zone 1 abgewandten Seite des Maximums fällt die Intensität der fundamentalen Mode I₁ flacher ab. Sie erstreckt sich durch die erste n-dotierte Schicht 4. Die Intensität der fundamentalen Mode innerhalb der n-dotierten Mantelschicht 6 ist vernachlässigbar klein.

Die aktive Zone 1, die erste undotierte Schicht 2, die zweite undotierte Schicht 3 und die zweite n-dotierte Schicht 5 bilden vorliegend einen primären Wellenleiter 81 aus, der dazu geeignet ist, die fundamentale Lasermode zu führen.

Die Intensitäten I₂, I₃ und I₄ der Moden zweiter, dritter und vierter Ordnung weisen ebenfalls innerhalb der zweiten n-dotierten Schicht 5 nahe der undotierten Schichten 2, 3 ein lokales Maximum auf, das jedoch jeweils deutlich kleiner ist, als der Wert des Maximums der fundamentalen Mode. Die Mode zweiter Ordnung hat hier ein Maximum von ca. 0,2, während das Maximum der Mode dritter Ordnung bei ca. 0,4 und das Maximum der Mode vierter Ordnung bei ca. 0,5 liegt.

Die aktive Zone 1, die erste undotierte Schicht 2, die zweite undotierte Schicht 3, die erste n-dotierte Schicht 4 und die zweite n-dotierte Schicht 5 bilden vorliegend einen sekundären Wellenleiter 82 aus, der dazu geeignet ist, die Lasermoden höherer Ordnung zu führen.

Der Gesamtwellenleiter 8 beinhaltet die Schichten des primären Wellenleiters 81 und die Schichten des sekundären Wellenleiters 82. Der Gesamtwellenleiter 8 wird vorliegend durch die aktive Zone 1, die erste undotierte Schicht 2, die zweite undotierte Schicht 3, die erste n-dotierte Schicht 4 und die zweite n-dotierte Schicht 5 gebildet.

Da die Moden höherer Ordnung, insbesondere der zweiten und der dritten Ordnung ein lokales Maximum innerhalb der zweiten n-dotierten Schicht 5 aufweisen, das deutlich kleiner ist, als das Maximum der fundamentalen Mode, ist die Wahrscheinlichkeit des Auftretens von Moden höherer Ordnung, insbesondere der zweiten oder dritten Ordnung vorteilhafterweise gering. Moden höherer Ordnung, in der Regel ab der vierten Ordnung, zeigen häufig Ausläufer in die Mantelschichten, in denen sie aufgrund der höheren Dotierung starke optische Verluste erfahren. Somit ist das Auftreten von Moden höherer Ordnung in der Regel eher gering.

Die Intensität I₂ der Mode zweiter Ordnung weist weiterhin ein einziges weiteres lokales Maximum innerhalb der ersten n-dotierten Schicht 4 bei einem Wert von ca. 1,0 und einer Position b von etwa 2,75 µm auf. Die Breite dieses weiteren Maximums beträgt hierbei ca. 1,6 µm.

Die Intensität I₃ der Mode der dritten Ordnung weist zwei weitere lokale Maxima jeweils mit einem Wert von ca. 0,8 auf, die ebenfalls innerhalb der ersten n-dotierten Schicht 4 positioniert sind. Die Breite dieser beiden Maxima beträgt hierbei ca. 1 µm. Die Maxima sind symmetrisch zum lokalen Minimum der Kurve bei einer Position b=2,9 µm angeordnet.

Die Intensität I₄ der Mode der vierten Ordnung weist drei weitere lokale Maxima jeweils mit einem Wert von ca. 0,7 auf. Auch diese weiteren lokalen Maxima der Intensität I₄ der Mode vierter Ordnung sind innerhalb der ersten n-dotierten Schicht 4 positioniert. Die Breite dieser drei Maxima beträgt hierbei ca. 0,7 µm und die Maxima sind symmetrisch zum Maximum des mittleren Maximums bei einer Position b=2,9 µm angeordnet.

Als Folge des Intensitätsverlaufes der unterschiedlichen Moden innerhalb des Halbleiterlasers nehmen die Werte der effektiven Brechungsindizes n_{eff1}, n_{eff2}, n_{eff3}, n_{eff4}, mit steigender Modenordnung ab. Der effektive Brechungsindex n_{eff1} der fundamentalen Mode beträgt ca. 3,38, der effektive Brechungsindex n_{eff2} der Mode zweiter Ordnung beträgt ca. 3,36, der effektive Brechungsindex n_{eff3} der Mode dritter Ordnung beträgt ca. 3,34 und der effektive Brechungsindex n_{eff4} der Mode vierter Ordnung beträgt ca. 3,33.

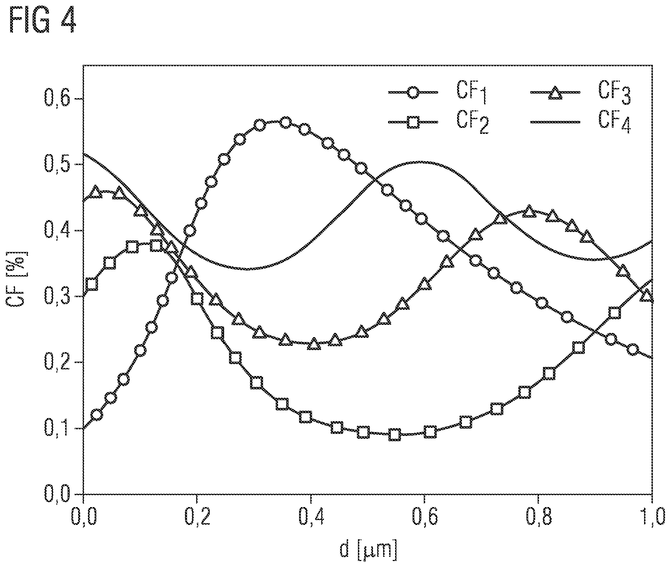

Figur 4 zeigt den Confinement-Faktor CF₁, CF₂, CF₃, CF₄ der fundamentalen Lasermode sowie der Moden zweiter, dritter und vierter Ordnung als Funktion der Dicke d der zweiten n-dotierten Schicht 5 für das Ausführungsbeispiel gemäß der Figuren 1, 2 und 3. Hierbei ist die gesamte Dicke des Gesamtwellenleiters 8 konstant gehalten. Sie beträgt in etwa 2,3 µm. Der Confinement-Faktor CF₁ der fundamentalen Lasermode weist einen maximalen Wert von ca. 0,55% bei einer Dicke d der zweiten n-dotierten Schicht 5 von ca. 0,3 µm auf, während die maximalen Werte der Confinement-Faktoren CF₂, CF₃, CF₄ der Lasermoden zweiter, dritter und vierter Ordnung deutlich zu höheren Werte der Dicke d der zweiten n-dotierten Schicht 5 verschoben sind. Weiterhin weist der Confinement-Faktor CF₁ der fundamentalen Lasermode beim Ursprung des Graphen, d.h. für den Fall, dass der Gesamtwellenleiter 8 frei ist von einer zweiten n-dotierte Schicht 5, einen Wert auf, der gegenüber den Werten des Confinement-Faktors der Moden zweiter, dritter und vierter Ordnung erniedrigt ist. Dies bedeutet, dass bei einem konventionellen Gesamtwellenleiter, der nur eine einzige n-dotierte Schicht aufweist und nicht zwei n-dotierte Schichten 4, 5, wie es vorliegend vorgesehen ist, der Confinement-Faktor CF₁ der fundamentalen Lasermode niedriger ist als der Confinement-Faktor CF₂, CF₃, CF₄ der Moden höherer Ordnung, so dass die Gefahr des Auftretens unerwünschter Lasermoden höherer Ordnung erhöht ist.

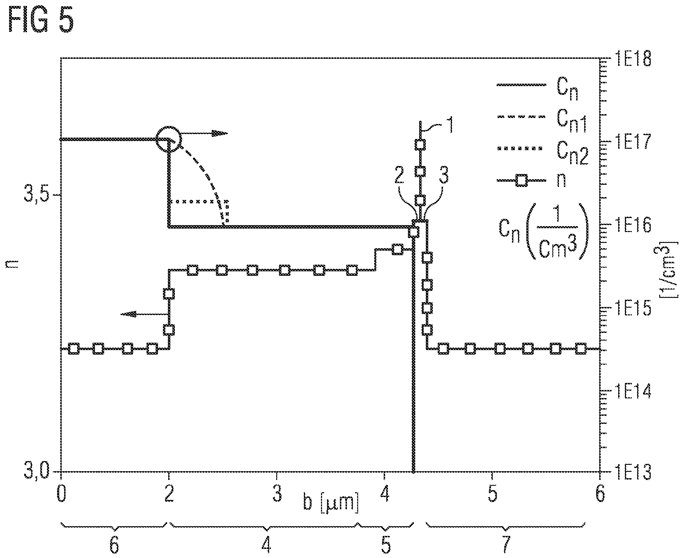

Figur 5 zeigt den Verlauf des Brechungsindexes n des kantenemittierenden Halbleiterlasers gemäß dem Ausführungsbeispiel der Figur 1, wie er bereits anhand der Figur 2 im Detail beschrieben wurde. Weiterhin ist in Figur 5 ein erstes n-Dotierungsprofil cₙ innerhalb des Halbleiterlasers schematisch dargestellt. Alternativ hierzu sind zwei weitere modifizierte n-Dotierungsprofile cₙ₁ und cₙ₂ schematisch dargestellt, bei denen die Dotierung zu Seite der ersten n-dotierten Schicht 4 ansteigt, die von der aktiven Zone 1 abgewandt ist. Die Seite der ersten n-dotierten Schicht 4, die von der aktiven Zone 1 abgewandt ist, bildet eine Außenseite des Gesamtwellenleiters 8 aus.

Als n-Dotierstoffe können hierbei beispielsweise Tellur oder Silizium verwendet sein.

Das erste n-Dotierungsprofil Cₙ weist innerhalb der n-dotierten Mantelschicht 6 eine Konzentration des n-Dotierstoffes von ca. 1 10¹⁷ cm⁻³ auf und fällt am Übergang zur ersten n-dotierten Schicht 4 auf einen Wert von ca. 1 10¹⁶ cm⁻³ ab. Die erste n-dotierte Schicht 4 und die zweite n-dotierte Schicht 5 weisen denselben n-Dotierstoffgehalt von 1 10¹⁶ cm⁻³ auf, dass heißt, das erste n-Dotierungsprofil Cₙ verläuft konstant bei einem Wert von ca. 1 10¹⁶ cm⁻³ innerhalb der ersten n-dotierten Schicht 4 und der zweiten n-dotierten Schicht 5. Beim Übergang zu dem undotierten Bereich, der durch die beiden undotierten Schichten 2, 3 gebildet wird, fällt das erste n-Dotierungsprofil Cₙ scharf gegen Null ab.

Das erste modifizierte n-Dotierungsprofil cₙ₁ steigt im Unterschied zum ersten n-Dotierungsprofil cₙ kontinuierlich innerhalb einer Dicke der ersten n-dotierten Schicht 4 von ca. 0,5 µm zu der Seite der ersten n-dotierten Schicht 4 an, die von der aktiven Zone 1 abgewandt ist. Das erste modifizierte n-Dotierungsprofil weist hierbei einen Verlauf gemäß einer umgekehrten Parabel auf.

Das zweite modifizierte n-Dotierungsprofil Cₙ₂ steigt ebenfalls wie das erste modifizierte n-Dotierungsprofil innerhalb einer Dicke von ca. 0,5 µm der ersten n-dotierten Schicht 4 zu der Seite der ersten n-dotierten Schicht 4 an, die von der aktiven Zone 1 abgewandt ist. Im Unterschied zu dem ersten modifizierten n-Dotierungsprofil cₙ₁ verläuft das zweite n-Dotierungsprofil Cₙ₂ jedoch gemäß einer Rechteckfunktion mit einem Wert von ca. 2 10¹⁶ cm⁻³.

Da die fundamentale Lasermode zu einem großen Teil auf die zweite n-dotierte Schicht 5 und die erste undotierte Schicht 2 begrenzt ist, kann mit Hilfe eines modifizierten n-Dotierungsprofil, wie anhand der Figur 5 exemplarisch beschrieben, die Verluste der Moden höherer Ordnung aufgrund von Absorption von freien Ladungsträgern vorteilhafterweise erhöht werden.

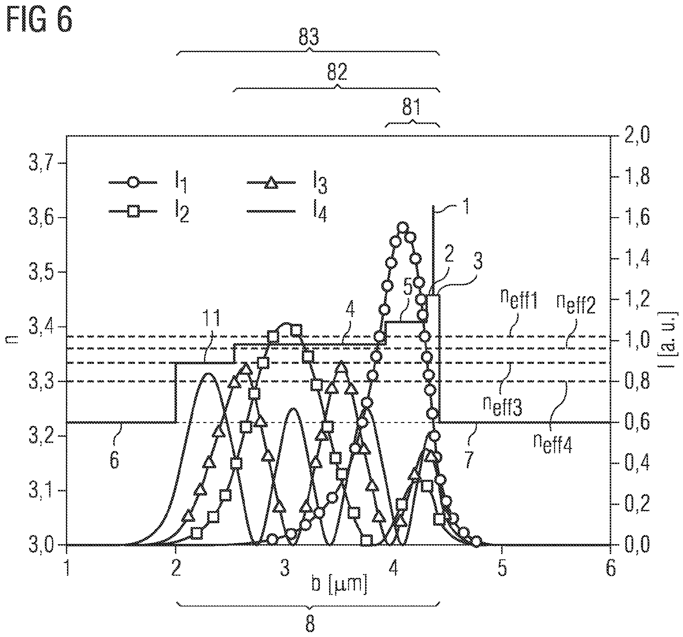

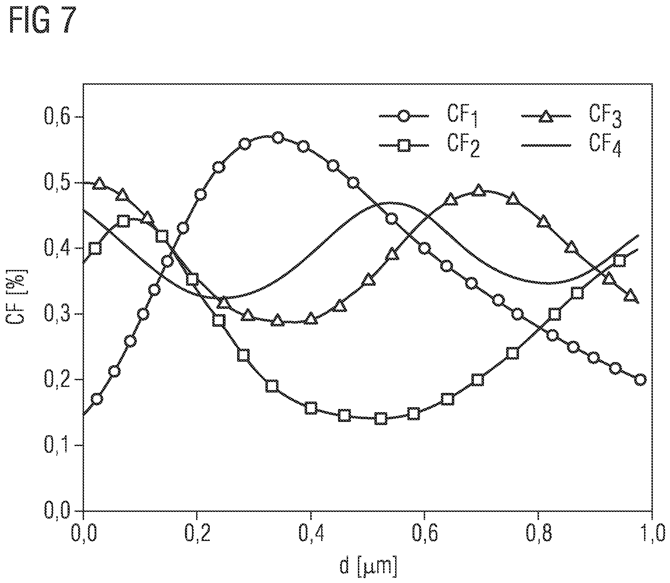

Der Halbleiterlaser gemäß dem zweiten Ausführungsbeispiel der Figuren 6 und 7 weist im Unterschied zu dem Halbleiterlaser gemäß dem ersten Ausführungsbeispiel der Figuren 1 bis 3 eine dritte n-dotierte Schicht 11 auf, die angrenzend an die erste n-dotierte Schicht 4 angeordnet ist. Um Wiederholungen zu vermeiden, werden im Folgenden insbesondere die Unterschiede des Halbleiterlasers gemäß dem zweiten Ausführungsbeispiel im Vergleich zu dem Halbleiterlaser gemäß dem ersten Ausführungsbeispiel beschrieben.

Die Dicke des Gesamtwellenleiters 8 gemäß dem zweiten Ausführungsbeispiel ist gegenüber dem ersten Ausführungsbeispiel konstant gehalten. Die dritte n-dotierte Schicht 11 weist eine Dicke von ca. 0,5 µm auf, während die erste n-dotierte Schicht 4 eine Dicke von 1,5 µm aufweist.

Die dritte n-dotierte Schicht 11 ist in direktem Kontakt zu der ersten n-dotierten Schicht 4 angeordnet. Der Brechungsindex n₃ der dritten n-dotierten Schicht 11 ist um einen zweiten Brechungsindexunterschied dn₂ geringer als der Brechungsindex n₁ der ersten n-dotierten Schicht 4.

Besonders bevorzugt liegt der zweite Brechungsindexunterschied dn₂ zwischen der ersten n-dotierten Schicht 4 und der dritten n-dotierten Schicht 5 ebenfalls zwischen 0,04 und 0,05, wobei die Grenzen eingeschlossen sein.

Mit Hilfe der dritten n-dotierten Schicht 11 und dem zweiten Brechungsindexunterschied dn₂ zwischen der ersten n-dotierten Schicht 4 und der dritten n-dotierten Schicht 11 wird vorliegend ein weiterer Wellenleiter 83 höherer Ordnung, nämlich ein Wellenleiter dritten Ordnung, geschaffen. Der Wellenleiter dritter Ordnung 83 trägt dazu bei, die Moden höherer Ordnung zu führen.

Der Wellenleiter dritter Ordnung 83 umfasst vorliegend die aktive Zone 1, die erste undotierte Schicht 2, die zweite undotierte Schicht 3, die erste n-dotierte Schicht 4, die zweite n-dotierte Schicht 5 und die dritte n-dotierte Schicht 11.

Der zweite Brechungsindexunterschied dn₂ zwischen der ersten n-dotierten Schicht 4 und der dritten n-dotierten Schicht 11 lässt das Intensitätsprofil I₁ der fundamentalen Mode im Wesentlichen unverändert, während die Intensitätsprofile I₂, I₃, I₄ der Moden höherer Ordnung eine geringfügige Änderung erfahren. So weist beispielsweise das Intensitätsprofil I₂ der Mode zweiter Ordnung gegenüber dem ersten Ausführungsbeispiel (vergleiche Figur 3) ein geringfügig höheres Maximum auf.

Figur 7 zeigt äquivalent zu Figur 4 den Confinement-Faktoren CF₁, CF₂, CF₃, CF₄ der fundamentalen Lasermode sowie der Moden zweiter, dritter und vierter Ordnung als Funktion der Dicke d der zweiten n-dotierten Schicht 5 für das Ausführungsbeispiel gemäß der Figur 6. Hierbei ist die Dicke der dritten n-dotierten Schicht 11 derart modifiziert, so dass die gesamte Dicke des Gesamtwellenleiters 8 konstant gehalten ist.

Wie Figur 7 zeigt, kann in die Halbleiterlaserstruktur gemäß der Figuren 1, 2 und 3 eine dritte n-dotierte Schicht 11 mit einem weiteren Brechungsindexunterschied dn₂ eingeführt werden, ohne dass sich die Performance des Halbleiterlasers wesentlich ändert.

Weiterhin zeigt Figur 7, dass die Confinement-Faktor CF₂, CF₃, CF₄ der höheren Moden bei einer Dicke der zweiten n-dotierten Schicht 5 von ca. 300 nm immer noch gegenüber dem Confinement-Faktor CF₁ der fundamentalen Mode unterdrückt sind.

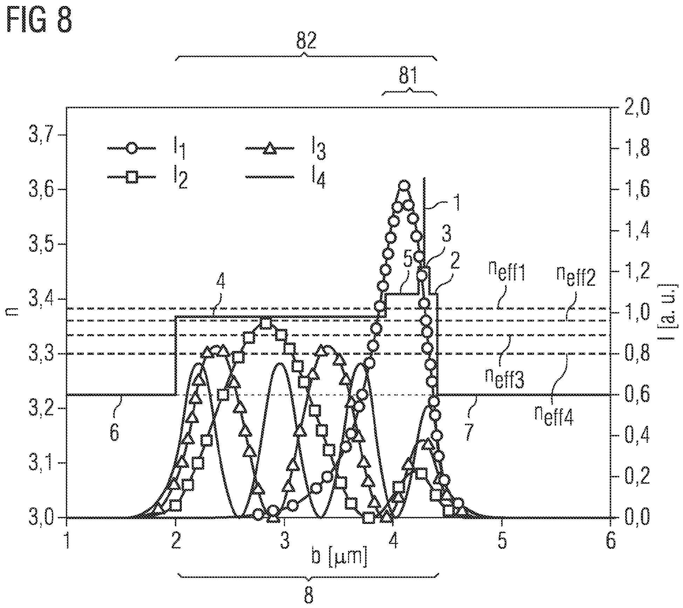

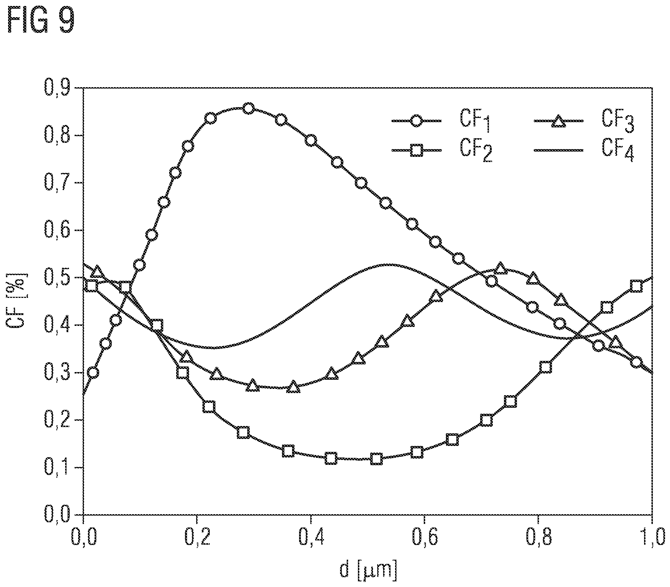

Der Halbleiterlaser gemäß dem dritten Ausführungsbeispiel der Figuren 8 und 9 weist im Unterschied zu dem Halbleiterlaser gemäß dem ersten Ausführungsbeispiel der Figuren 1 bis 3 eine sehr dünne p-dotierte Schicht 12 innerhalb des Gesamtwellenleiters 8 auf.

Um Wiederholungen zu vermeiden, werden im Folgenden insbesondere die Unterschiede des Halbleiterlasers gemäß dem dritten Ausführungsbeispiel im Vergleich zu dem Halbleiterlaser gemäß dem ersten Ausführungsbeispiel beschrieben.

Die p-dotierte Schicht 12 ist zwischen der p-dotierten Mantelschicht 7 und der zweiten undotierten Schicht 3 angeordnet. Sie weist in etwa denselben Brechungsindex wie die zweite n-dotierte Schicht 5 auf. Die p-dotierte Schicht 12 ist besonders bevorzugt nicht dicker als 10% der Dicke des Gesamtwellenleiters 8. Vorliegend weist die p-dotierte Schicht 12 eine Dicke von ca. 50 nm auf.

Betrachtet man die Intensitätsprofile I₂, I₃, I₄ der Moden zweiter, dritter und vierter Ordnung der Figur 8 im Vergleich zu Figur 3, so kann man sehen, dass sich diese durch die Einführung der p-dotierten Schicht 12 nicht wesentlich ändern. Die aktive Zone 1 jedoch wird aufgrund der p-dotierten Schicht 12 in Richtung des Maximums der fundamentalen Mode verschoben, so dass der Confinement-Faktor CF₁ der fundamentalen Mode wesentlich erhöht wird.

Die Confinement-Faktoren der fundamentalen Lasermode sowie der Lasermoden zweiter, dritter und vierter Ordnung des dritten Ausführungsbeispieles in Abhängigkeit der Dicke d der zweiten n-dotierten Schicht 5 sind in Figur 9 dargestellt. Hierbei ist die Dicke der p-dotierten Schicht 12 konstant gehalten und die Dicke der ersten n-dotierten Schicht 4 variiert, so dass die Dicke des Gesamtwellenleiters 8 konstant bleibt.

Figur 9 zeigt, dass der Verlauf der Confinement-Faktoren CF₂, CF₃, CF₄ der Moden höherer Ordnung im Wesentlich unverändert bleibt, während das Maximum des Confinement-Faktors CF₁ der fundamentalen Lasermode gegenüber dem ersten Ausführungsbeispiel auf ca. 0,85% erhöht ist. Diese Patentanmeldung beansprucht die Priorität der deutschen Patentanmeldung DE 10 2009 041 934.9, deren Offenbarungsgehalt hiermit durch Rückbezug aufgenommen wird.

## Patentansprüche

1. Kantenemittierender Halbleiterlaser mit:
- einer aktiven, strahlungserzeugenden Zone (1), und
- einem Gesamtwellenleiter (8), der dazu geeignet ist, die in der aktiven Zone (1) erzeugte Strahlung innerhalb des Halbleiterlasers zu führen, wobei
- der Gesamtwellenleiter (8) eine erste n-dotierte Schicht (4) und eine zweite n-dotierte Schicht (5) umfasst, wobei die zweite n-dotierte Schicht (4) zwischen der ersten n-dotierten Schicht (4) und der aktiven Zone (1) angeordnet ist und die fundamentale Mode der Laserstrahlung im Wesentlichen auf die zweite n-dotierte Schicht begrenzt ist,
- der Brechungsindex n₂ der zweiten n-dotierten Schicht (5) um einen Betrag dn größer ist als der Brechungsindex n₁ der ersten n-dotierten Schicht (4), **dadurch gekennzeichnet dass** der Gesamtwellenleiter (8) frei ist von einer p-dotierten Schicht (12), oder der Gesamtwellenleiter (8) eine einzige p-dotierte Schicht (12) aufweist, deren Dicke nicht größer ist als 10% der Dicke des Gesamtwellenleiters (8).

2. Halbleiterlaser nach dem vorherigen Anspruch, bei dem der Gesamtwellenleiter (8) einen primären Wellenleiter (81) und einen sekundären Wellenleiter (82) aufweist, wobei die erste n-dotierte Schicht (4) Teil des sekundären Wellenleiters (82) ist.

3. Halbleiterlaser nach einem der obigen Ansprüche, bei dem der Gesamtwellenleiter (8) weiterhin eine erste undotierte Schicht (2) aufweist, die zwischen der aktiven Zone (1) und der zweiten n-dotierten Schicht (5) angeordnet ist, wobei der Brechungsindex n₃ der ersten undotierten Schicht (2) größer ist als der Brechungsindex n₂ der zweiten n-dotierten Schicht (5) .

4. Halbleiterlaser nach dem vorherigen Anspruch, bei dem der Gesamtwellenleiter (8) eine zweite undotierte Schicht (3) aufweist, die auf der Seite der aktiven Zone (1) angeordnet ist, die der ersten undotierten Schicht (2) gegenüber liegt.

5. Halbleiterlaser nach einem der obigen Ansprüche, bei dem die erste undotierte Schicht (2) und die zweite undotierte Schicht (3) unterschiedliche Dicken aufweisen.

6. Halbleiterlaser nach einem der obigen Ansprüche, der weiterhin eine n-dotierte Mantelschicht (6) und eine p-dotierte Mantelschicht (7) aufweist.

7. Halbleiterlaser nach einem der obigen Ansprüche, bei dem der Brechungsindexunterschied dn zwischen der ersten n-dotierten Schicht (4) und der zweiten n-dotierten Schicht (5) zwischen 0,03 und 0,1 liegt, wobei die Grenzen eingeschlossen sind.

8. Halbleiterlaser nach einem der obigen Ansprüche, bei dem die Dicke der zweiten n-dotierten Schicht (5) einen Wert zwischen 8% und 20% aufweist, bezogen auf die Dicke des Gesamtwellenleiters (8).

9. Halbleiterlaser nach dem vorherigen Anspruch, bei dem die Dicke der zweiten n-dotierten Schicht (5) zwischen 200 nm und 800 nm liegt, wobei die Grenzen eingeschlossen sind.

10. Halbleiterlaser nach einem der obigen Ansprüche, bei dem der n-Dotierstoff in der ersten n-dotierten Schicht (4) stufenartig oder kontinuierlich zu einer Außenseite des Gesamtwellenleiters (8) hin ansteigt.

11. Halbleiterlaser nach einem der obigen Ansprüche, der auf einem Arsenid-Verbindungshalbleitermaterial basiert.

12. Halbleiterlaser nach einem der obigen Ansprüche, der Laserstrahlung aus dem infraroten Spektralbereich aussendet.

## Claims

1. Edge emitting semiconductor laser comprising:
- an active, radiation-generating zone (1), and
- a common waveguide (8), which is suitable for guiding the radiation generated in the active zone (1) within the semiconductor laser, wherein
- the common waveguide (8) comprises a first n-doped layer (4) and a second n-doped layer (5), wherein the second n-doped layer (5) is arranged between the first n-doped layer (4) and the active zone (1) and the fundamental mode of the laser radiation is substantially limited to the second n-doped layer,
- the refractive index n₂ of the second n-doped layer (5) is greater than the refractive index n₁ of the first n-doped layer (4) by a value dn,
**characterized in that**
the common waveguide (8) is free of a p-doped layer (12), or the common waveguide (8) has a single p-doped layer (12), the thickness of which is not greater than 10% of the thickness of the common waveguide (8)..

2. Semiconductor laser according to the preceding claim, wherein the common waveguide (8) has a primary waveguide (81) and a secondary waveguide (82), wherein the first n-doped layer (4) is part of the secondary waveguide (82).

3. Semiconductor laser according to any of the preceding claims, wherein the common waveguide (8) furthermore has a first undoped layer (2), which is arranged between the active zone (1) and the second n-doped layer (5), wherein the refractive index n₃ of the first undoped layer (2) is greater than the refractive index n₂ of the second n-doped layer (5).

4. Semiconductor laser according to the preceding claim, wherein the common waveguide (8) has a second undoped layer (3), which is arranged on the side of the active zone (1) which lies opposite the first undoped layer (2).

5. Semiconductor laser according to any of the preceding claims, wherein the first undoped layer (2) and the second undoped layer (3) have different thicknesses.

6. Semiconductor laser according to any of the preceding claims, which furthermore has an n-doped cladding layer (6) and a p-doped cladding layer (7).

7. Semiconductor laser according to any of the preceding claims, wherein the refractive index difference dn between the first n-doped layer (4) and the second n-doped layer (5) is between 0.03 and 0.1, inclusive of the limits.

8. Semiconductor laser according to any of the preceding claims, wherein the thickness of the second n-doped layer (5) has a value of between 8% and 20%, relative to the thickness of the common waveguide (8).

9. Semiconductor laser according to the preceding claim, wherein the thickness of the second n-doped layer (5) is between 200 nm and 800 nm, inclusive of the limits.

10. Semiconductor laser according to any of the preceding claims, wherein the n-type dopant in the first n-doped layer (4) rises in a stepped manner or continuously towards an outer side of the common waveguide (8).

11. Semiconductor laser according to any of the preceding claims, which is based on an arsenide compound semiconductor material.

12. Semiconductor laser according to any of the preceding claims, which emits laser radiation from the infrared spectral range.

## Revendications

1. Laser à semi-conducteur émettant par la tranche, comprenant ;
- une zone (1) active générant un rayonnement, et
- un guide d'ondes complet (8) qui est apte à guider à l'intérieur du laser à semi-conducteur le rayonnement généré dans la zone active (1),
- le guide d'ondes complet (8) comprenant une première couche (4) dopée n et une deuxième couche (5) dopée n, la deuxième couche (5) dopée n étant disposée entre la première couche (4) dopée n et la zone active (1), et le mode fondamental du rayonnement laser étant essentiellement limité à la deuxième couche dopée n,
- l'indice de réfraction n₂ de la deuxième couche (5) dopée n étant supérieur d'un montant dn à l'indice de réfraction n₁ de la première couche (4) dopée n, **caractérisé en ce que**
le guide d'ondes complet (8) est exempt d'une couche (12) dopée p ou
**en ce que** le guide d'ondes complet (8) présente une seule couche (12) dopée p, dont l'épaisseur n'est pas supérieure de 10% à l'épaisseur du guide d'ondes complet (8).

2. Laser à semi-conducteur selon la revendication précédente, dans lequel le guide d'ondes complet (8) présente un guide d'ondes primaire (81) et un guide d'ondes secondaire (82), la première couche (4) dopée n faisant partie du guide d'ondes secondaire (82).

3. Laser à semi-conducteur selon l'une quelconque des revendications précédentes, dans lequel le guide d'ondes complet (8) présente en outre une première couche (2) non dopée qui est disposée entre la zone active (1) et la deuxième couche (5) dopée n, l'indice de réfraction n₃ de la première couche (2) non dopée étant supérieur à l'indice de réfraction n₂ de la deuxième couche (5) dopée n.

4. Laser à semi-conducteur selon la revendication précédente, dans lequel le guide d'ondes complet (8) présente en outre une deuxième couche (3) non dopée qui est disposée sur le côté de la zone active (1), qui est opposé à la première couche (2) non dopée.

5. Laser à semi-conducteur selon l'une quelconque des revendications précédentes, dans lequel la première couche (2) non dopée et la deuxième couche (3) non dopée présentent des épaisseurs différentes.

6. Laser à semi-conducteur selon l'une quelconque des revendications précédentes, lequel présente en outre une couche de revêtement (6) dopée n et une couche de revêtement (7) dopée p.

7. Laser à semi-conducteur selon l'une quelconque des revendications précédentes, dans lequel la différence d'indice de réfraction dn entre la première couche (4) dopée n et la deuxième couche (5) dopée n est située entre 0,03 et 0,1, les limites étant inclues.

8. Laser à semi-conducteur selon l'une quelconque des revendications précédentes, dans lequel l'épaisseur de la deuxième couche (5) dopée n présente une valeur comprise entre 8% et 20% par rapport à l'épaisseur du guide d'ondes complet (8).

9. Laser à semi-conducteur selon la revendication précédente, dans lequel l'épaisseur de la deuxième couche (5) dopée n est située entre 200 nm et 800 nm, les limites étant inclues.

10. Laser à semi-conducteur selon l'une quelconque des revendications précédentes, dans lequel le dopant n dans la première couche (4) dopée n augmente progressivement ou continuellement vers un côté extérieur du guide d'ondes complet (8).

11. Laser à semi-conducteur selon l'une quelconque des revendications précédentes, lequel est basé sur un matériau semi-conducteur composé d'arsénique.

12. Laser à semi-conducteur selon l'une quelconque des revendications précédentes, lequel émet un rayonnement laser de la plage spectrale des infrarouges.
